(19) Europäisches Patentamt
European Patent Office
Office européen des brevets

(11) **EP 2 285 003 B1**

(12) **EUROPEAN PATENT SPECIFICATION**

(45) Date of publication and mention
of the grant of the patent:
**13.11.2019 Bulletin 2019/46**

(51) Int Cl.:
***H03M 13/15*** *(2006.01)*

(21) Application number: **09305751.1**

(22) Date of filing: **12.08.2009**

(54) **Correction of errors in a codeword**

Korrektur von Fehlern in einem Kennwort

Correction d'erreurs dans un mot de code

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(43) Date of publication of application:
**16.02.2011 Bulletin 2011/07**

(73) Proprietor: **Alcatel Lucent
91620 Nozay (FR)**

(72) Inventors:
• **Costantini, Carlo
23880 Casatenovo (IT)**
• **Cattaneo, Davide
23890 Barzago (IT)**
• **Gemelli, Riccardo
20019 Settimo Milanese (IT)**
• **Ronchetti, Luigi
22100 Como (IT)**

(74) Representative: **Browne, Robin Forsythe et al
Hepworth Browne
15 St Paul's Street
Leeds LS1 2JG (GB)**

(56) References cited:
**EP-A2- 0 147 623**

• **STEVEN S GORSHE ET AL: "Transparent Generic Framing Procedure (GFP): A Protocol for Efficient Transport of Block-Coded Data through SONET/SDH Networks" IEEE COMMUNICATIONS MAGAZINE, IEEE SERVICE CENTER, PISCATAWAY, US, vol. 40, no. 5, 1 May 2002 (2002-05-01), pages 88-95, XP011092831 ISSN: 0163-6804**
• **GORSHE S S: "CRC-16 POLYNOMIALS OPTIMIZED FOR APPLICATIONS USING SELF-SYNCHRONOUS SCRAMBLERS" PROCEEDINGS OF IEEE INTERNATIONAL CONFERENCE ON COMMUNICATIONS - 28 APRIL-2 MAY 2002 - NEW YORK, NY, USA, IEEE, PISCATAWAY, NJ, USA, vol. 5, 28 April 2002 (2002-04-28), pages 2791-2795, XP001195032 ISBN: 978-0-7803-7400-3**
• **R.M.Roth: In: "Introduction to coding theory" 2006, Cambridge , XP002564841 , pages 29-36 * page 29 - page 36 ***

**Description**

**Technical field**

The present invention generally relates to the field of communication networks. More particularly, the present invention relates to a method and device for correcting errors in a codeword transmitted over a link of a communication network.

**Background art**

In a communication network, binary data sequences are typically transmitted over the links of the communication network in the form of optical or electric signals. Each signal typically has an optical or electrical carrier that, at the transmission side, is modulated by means of the binary data sequence. At the reception side, the signal is demodulated, thus allowing to recover the binary data sequence.

However, during transmission over the link, the signal often undergoes degradation due to noise, attenuation, dispersion, interference, etc. Degradation of the signal may negatively affect demodulation, and may result in a recovered binary data sequence different from the original binary data sequence. In other words, the recovered binary data sequence may contain one or more errors, i.e. one or more bits having a value different from the value of the corresponding bits in the original digital data sequence.

The "Cyclic Redundancy Check" technique (or, briefly, CRC technique) is a well known technique allowing to detect errors in a recovered binary data sequence. According to the CRC technique, a binary data sequence A of k bits $(A_{k-1}, ..., A_2, A_1, A_0)$ to be transmitted is associated to a polynomial A(x) equal to:

$$A(x) = A_{k-1}x^{k-1} + \ldots + A_2x^2 + A_1x^1 + A_0x^0. \qquad [1]$$

At the transmission side, the polynomial A(x) is multiplied by $x^{n-k}$ and then divided by a so-called generator polynomial G(x) having degree equal to n-k:

$$G(x) = x^{n-k} + G_{n-k-1}x^{n-k-1} + \ldots + G_2x^2 + G_1x^1 + x^0, \qquad [2]$$

where $G_{n-k}$ and $G_0$ are equal to "1" by definition.

By defining Q(x) as the quotient polynomial obtained by dividing $A(x) \cdot x^{n-k}$ by G(x), and R(x) as the remainder polynomial of degree n-k-1 obtained by dividing $A(x) \cdot x^{n-k}$ by G(x), the operation can be written as:

$$A(x) \cdot x^{n-k} = Q(x) \, G(x) + R(x). \qquad [3]$$

According to the CRC technique, the coefficients $(R_{n-k-1}, ..., R_2, R_1, R_0)$ of the remainder polynomial R(x) are the check sequence of the data sequence A. At the transmission side, the data sequence $(A_{k-1}, ..., A_2, A_1, A_0)$ and the check sequence $(R_{n-k-1}, ..., R_2, R_1, R_0)$ are concatenated, thus forming a so-called "codeword" $(A_{k-1}, ..., A_2, A_1, A_0, R_{n-k-1}, ..., R_2, R_1, R_0)$ of n bits, which is transmitted along the link. The polynomial associated to the codeword is:

$$V(x) = A(x) \cdot x^{n-k} + R(x) \qquad [4]$$

By adding R(x) at both sides of equation [3], it follows that:

$$A(x) \cdot x^{n-k} + R(x) = Q(x) \, G(x), \qquad [5]$$

since R(x)+R(x)=0 (assuming that "+" indicates a bit-per-bit XOR operation). In other words, the polynomial V(x) associated to the transmitted codeword is multiple of the generator polynomial G(x).

At the reception side, the codeword is recovered. The recovered codeword may be different from the transmitted codeword, in that it may contain one or more errors. Therefore, if V'(x) is the polynomial associated to the recovered codeword, V'(x)=V(x)+E(x), E(x) being a polynomial with degree n-1 corresponding to an error pattern introduced by transmission over the link. In the present description, the expression "error pattern" will designate a sequence of n bits (i.e. having the same length as the codeword and the recovered codeword), wherein all the bits are equal to zero except the bit(s) placed in position(s) corresponding to the one ore more errors of the recovered codeword.

At the reception side, a so-called syndrome of the recovered codeword is calculated, the syndrome S(x) being defined as:

$$S(x)=R_{G(x)}[V'(x)], \qquad\qquad [6]$$

i.e. the remainder obtained dividing the polynomial V'(x) associated to the recovered codeword by the generator polynomial G(x). The syndrome S(x) has degree n-k-1.

By substituting V'(x) with V(x)+E(x) in equation [6], it follows that:

$$S(x)=R_{G(x)}[V(x)+E(x)]=R_{G(x)}[V(x)]+R_{G(x)}[E(x)]. \qquad\qquad [7]$$

However, as mentioned above, the polynomial V(x) associated to the transmitted codeword is a multiple of the generator polynomial G(x), and therefore: $R_{G(x)}[V(x)]=0$. It follows that:

$$S(x)=R_{G(x)}[E(x)], \qquad\qquad [8]$$

i.e. the syndrome S(x) depends exclusively on the error pattern introduced by transmission over the link, while it is independent of the transmitted codeword.

Therefore, if the syndrome S(x) calculated at the reception side is equal to zero, it is determined that the recovered codeword does not contain any error, and accordingly is equal to the transmitted codeword. Otherwise, if the calculated syndrome S(x) is not equal to zero, it is determined that the recovered codeword contains one or more errors.

Besides allowing detection of errors, it is known using the syndrome S(x) at the reception side for correcting errors in recovered codewords. As mentioned above, the syndrome S(x) exclusively depends on the error pattern E(x). Therefore, correcting errors in a recovered codeword requires calculating the syndrome S(x) and identifying the error pattern E(x) that generated such a syndrome.

To this purpose, a table of syndrome vs. error pattern may be used. Alternatively, W.W. Peterson et al., "Error Correcting Codes", The MIT Press (1972), pages 232-234 describes using a Meggitt decoder.

US 4 382 300 discloses that a received cyclic code word is clocked into a first register. As soon as the whole received word has been read in, it is parallel-loaded into a storage register. The syndrome is then formed of the stored code word. This syndrome is coupled to a logic circuit which determines whether the last stored bit is in error. This decision is modulo-2 added with the last bit, the output being the correct version of the last bit which is then clocked into the input of the storage register. The operation is repeated a given number of times at the end of which the maximum likelihood decision on r(x)-the cyclic code word-is present in the storage register, ready to be read out.

US 7 260 767 discloses methods for correcting errors in a GFP-T superblock include buffering the 64 bytes of data in an 8x8 byte buffer, buffering the flag byte in a separate buffer, calculating the CRC remainder, and performing single and double bit error correction in three stages. In the first stage, the CRC remainder is compared to a single bit error syndrome table and if an error is located, it is corrected. In the second stage, the CRC remainder is compared to a double bit error syndrome table and if an error is located, it is corrected. The third stage corrects the second error of a double bit error. The flag byte is processed first, followed by the data bytes, eight bytes at a time.

US 7 353 446 discloses a circuit for detecting and correcting errors in a bit stream. The circuit consists of a plurality of circuit elements, a least one operation circuit means, and at least two logic gates. The logic gates receive inputs from the plurality of circuit elements. The plurality of circuit elements are coupled to receive and store a portion of a bit stream. The operation circuit elements perform bitwise operations on the contents of at least two of the circuit elements. The bitwise operations are dictated by a cyclical redundancy check (CRC) polynomial and are used to perform the CRC error detection division operation. At the end of the division process for the data to be checked, each circuit element corresponds to a bit in a bit error pattern syndrome and the logic gates determine if the contents of the circuit elements match specific bit error patterns. The circuit causes the state of at least one bit in the bit stream to change if the contents of the plurality of circuit elements match one of the specific bit patterns.

EP 0 147 623 discloses a method for converting error syndromes to pointers which identify the position of erroneous bits. Each syndrome is converted by a plurality of hashing functions into a plurality of hash words, which in turn are used to address a plurality of read-only stores. The outputs of the read-only stores are logically combined to obtain a respective error pointer. A preferred embodiment uses three hashing functions and three read-only stores, and combines their outputs by an Exclusive-Or function.

## Summary of the invention

The Applicant has noticed that the above techniques for correcting errors using the syndrome S(x) have some drawbacks.

As to the table of syndrome vs. error pattern, it is disadvantageously very memory-consuming because it should be stored in a ROM having at least $2^{n-k}$ words, each word having n bits.

As to the Meggitt decoder, it is disadvantageously very complex to implement because it is based on a bit serial approach. In fact, because of very high current communication speeds, a very high degree of parallelism is required and this complicates a lot the implementation. Moreover this technique is not suitable to correct errors duplicated by a line self synchronous scrambler.

Also the solutions of US 4 382 300 and US 7 260 767, that use a Meggitt decoder, have the same drawbacks (serial approach, non applicability in combination with line self synchronous scrambler).

As to the solution of US 7 353 446, it is specific for GFP-T frames, and accordingly cannot be applied to any other code.

An object of the present invention is therefore providing a method for correcting one or more errors in a codeword that uses the above defined syndrome S(x), but that is simpler and faster than the above known techniques and that can be used also when codewords are scrambled.

The invention is defined by the set of claims.

## Brief description of the drawings

The present invention will become clearer by reading the following detailed description, given by way of example and not of limitation, to be read by referring to the accompanying drawings, wherein:

- Figure 1 schematically shows a communication network suitable for transmitting binary data sequences in the form of codewords;
- Figure 2 schematically shows an error corrector suitable for use in the communication network of Figure 1, according to a preferred embodiment of the present invention;
- Figure 3 schematically shows the content of an error correction table of the error corrector of Figure 2;
- Figure 4 schematically shows a preferred parallel implementation of the error corrector of Figure 2;
- Figure 5 schematically shows a preferred serial implementation of the error corrector of Figure 2;
- Figure 6 shows in detail the content of the error correction table of the error corrector of Figure 5; and
- Figure 7 is a flow chart of the operation of the error corrector of Figure 5.

## Detailed description of preferred embodiments of the invention

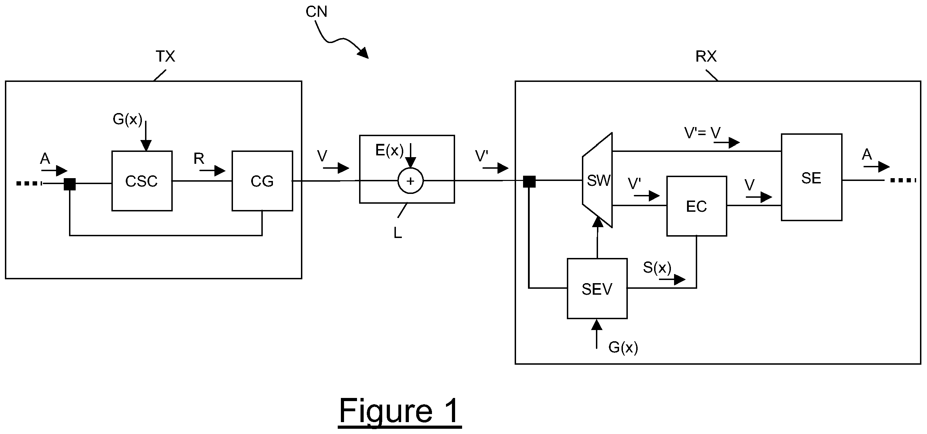

Figure 1 schematically shows a communication network CN suitable for transmitting binary data sequences in the form of codewords. The communication network CN comprises a network element acting as transmitter TX (briefly termed "transmitter" in the following description), a further network element acting as receiver RX (briefly termed "receiver" in the following description) and a link L connecting the transmitter TX and the receiver RX.

The transmitter TX preferably comprises a check sequence calculator CSC and a codeword generator CG. The transmitter TX may also comprise a scrambler that, for simplicity, is not shown in Figure 1. The receiver RX preferably comprises a syndrome evaluator SEV, a switch SW, an error corrector EC and a sequence extractor SE. If the transmitter TX comprises a scrambler, the receiver RX further comprises a de-scrambler that, for simplicity, is not shown in Figure 1. The transmitter TX and the receiver RX may comprise other modules, that are not shown in Figure 1 since they are not relevant to the present description. The link L may be either a wired link (e.g. an optical fiber link or an electrical link) or a wireless link.

It is assumed that a binary data sequence A associated to a polynomial A(x) have to be transmitted from the transmitter TX to the receiver RX. For instance, in case the communication network CN is packet-switched, the binary data sequence A may be the payload of a packet. The packet may be for instance an Ethernet packet, a GFP frame (in particular, a GFP-T frame), an ATM cell, and so on.

The binary data sequence A to be transmitted enters the check sequence calculator CSC, that preferably calculates its check sequence R using a generator polynomial G(x), as described above (see in particular the above equation [3]). The check sequence R is then sent to the codeword generator CG, that generates a codeword V associated to a polynomial V(x) by concatenating the binary data sequence A and the check sequence R. The codeword V is optionally scrambled, and then transmitted over the link L e.g. in the form of an optical or electrical signal.

As explained above, during transmission over the link L the signal transporting the codeword V may undergo degradation inducing errors when the codeword is recovered at the receiver RX. The recovered codeword is indicated in Figure 1 as V'. As explained in the introduction, the recovered codeword V' is associated to a polynomial V'(x)=V(x)+E(x), E(x) being the polynomial associated to the error pattern induced on the codeword by transmission over the link L.

At the receiver RX, the recovered codeword V' is possibly de-scrambled, and then sent to the syndrome evaluator SEV, that preferably evaluates the syndrome S(x) as the remainder obtained dividing the polynomial V'(x) associated to the recovered codeword V' by the generator polynomial G(x). The syndrome evaluator SEV then preferably determines whether the syndrome S(x) is equal to zero.

In the affirmative, the syndrome evaluator SEV determines that the recovered codeword V' does not contain any error, i.e. is it equal to the codeword V. Then, the syndrome evaluator SEV preferably instructs the switch SW to forward the recovered codeword V'=V to the sequence extractor SE, that preferably extracts the binary data sequence A from the codeword V by removing the check sequence R.

In the negative, the syndrome evaluator SEV determines that the recovered codeword V' contains one or more errors. Accordingly, the syndrome evaluator SEV preferably forwards the syndrome S(x) to the error corrector EC, and instructs the switch SW to forward the recovered codeword V' to the error corrector EC. The error corrector EC preferably uses the syndrome S(x) for determining the error pattern affecting the recovered codeword V' and, if possible, corrects the one or more errors, thus recovering the codeword V. The error corrector EC then forwards the codeword V to the sequence extractor SE, that preferably extracts the binary data sequence A from the codeword V by removing the check sequence R.

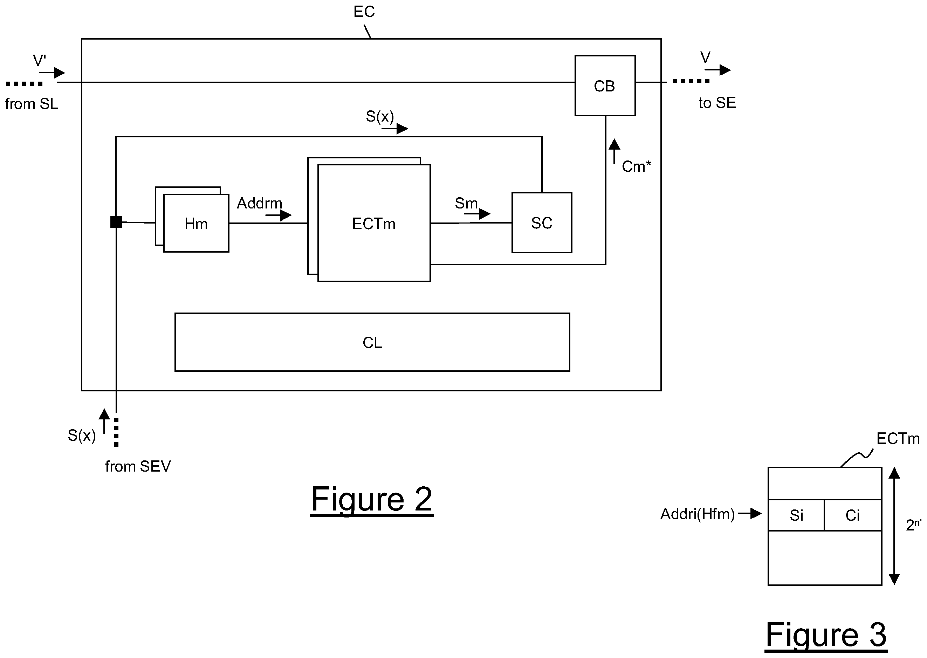

The error corrector EC according to a preferred embodiment of the present invention is schematically shown in Figure 2.

The error corrector EC preferably comprises a number M of address calculators Hm (m=1, 2, ... M), a number M of error correction tables ECTm (m=1, 2, ... M), a syndrome comparator SC, a correction block CB and a control logic CL. The criteria for choosing the value of M will be described in detail herein after.

The M error correction tables ECTm are preferably generated and stored at the receiver RX before starting transmission of digital data sequences from the transmitter TX to the receiver RX. For generating the M error correction tables ECTm, firstly a set of correctable error patterns Ei (i=1, 2, ..., N) that may affect the recovered codewords due to transmission over the link L is preferably identified. The set of correctable error patterns Ei depends on the protocol used for transmitting the binary data sequences from the transmitter TX to the receiver RX.

For instance, in case the binary data sequences are transmitted using the known GFP-T protocol, data sequences are encapsulated in GFP-T frames. The payload of a GFP-T frame comprises a certain number of GFP-T superblocks with fixed length of 67 bytes (i.e. 67x8 bits), having the informative part with length of 65 bytes (i.e. 65x8 bits). In other words a GFP-T superblock is a codeword with n = 536 bits, k = 520 bits and n-k = 16 bits (redundancy). For each GFP-T superblock, the check sequence is calculated using the generator polynomial G(x) of degree 16 $G(x)=x^{16}+x^{15}+x^{12}+x^{10}+x^4+x^3+x^2+x+1$. Accordingly, the check sequence of 16 bits is added to each GFP-T superblock. Using the above generator polynomial G(x) with codewords of 536 bits gives raise to a minimum Hamming distance between two codewords equal to 4. This implies that only single-bit errors can be corrected in a codeword. However, according to the GFP-T protocol, each codeword undergoes scrambling before transmission over the link. Scrambling is performed with a self-synchronous scrambler with polynomial $x^{43}+1$. The effect of scrambling is that each single-bit error in a codeword is duplicated at a distance of 43 bits. Accordingly, the correctable error patterns in a codeword of this type are:

- 1 "error pattern" with no error;
- 43 error patterns, each including a single error in the positions 0, 1, ..., 42;
- 493 error patterns, each including twin errors in the positions (0 and 43), (1 and 44), ...(536-44 and 536-1); and
- 43 error patterns, each including a single error in the positions 536-43, 536-42, ... 536-1.

The overall number of correctable error patterns, in case of GFP-T protocol, is therefore N=1+43+493+43=580.

After identification of the set of correctable error patterns Ei, the respective syndromes Si (i=1, 2, ..., N) are computed, using the generator polynomial G(x). As the generator polynomial G(x) has degree n-k (e.g. 16, in the above example of GFP-T), the syndromes Si derived from such generator polynomial G(x) have degree n-k-1 (e.g. 15, so they are defined by 16 binary coefficients).

According to preferred embodiments of the present invention, the syndromes Si (i.e. the sequences of their coefficients) calculated for the correctable error patterns Ei are mapped into corresponding sequences (that, herein after, will be termed "addresses") having a reduced length n'<n-k. The length n' is preferably chosen so that the number of possible addresses is equal to or higher than the number N of correctable error patterns. In particular, n' is preferably chosen as the smallest integer such that $2^{n'} \geq N$. For instance, in the above example of the GFP-T protocol, where n-k is equal to 16 and N is equal to 580, n' may be chosen equal to 10, since $2^{10}=1024>580$.

According to preferred embodiments of the invention, the addresses are calculated starting from the coefficients of the syndromes Si using one or more hash functions. As known, a hash function is a mathematical function that receives at its input a sequence (i.e. the coefficients of the syndrome Si) and provides at its output a sequence of reduced length (i.e. the address).

The Applicant has noticed that, if a single hash function is used for calculating the addresses, two or more syndromes Si may collide, i.e. the hash function may provide at its output the same address for two or more syndromes Si. The smaller n', the higher is the number of collisions.

According to preferred embodiments of the present invention, a set of M hash functions Hfm (m=1, 2, ... M) is used. The M hash functions HFm are preferably selected by means of a computer search technique, so that no more than M syndromes Si may collide. Exemplary sets of M hash functions that may be used are the remainders of division by a set of M different integers or the remainders of division by a set of M different polynomials.

The syndromes Si are preferably input at each of the M hash functions Hfm (m=1, 2, ... M), thus generating M sets of addresses Addri(Hfm) (where i=1, 2, ..., N and m=1, 2, ... M). Then, M error correction tables ECTm are built, each having $2^{n'}$ rows. As shown in Figure 3, in the m-th error correction table ECTm, a row placed at a given address Addri(Hfm) preferably stores the syndrome Si from which the address Addri(Hfm) has been derived applying the hash function Hfm, and correction information Ci allowing to correct the corresponding correctable error pattern Ei. Preferably, in rows placed at addresses other than the addresses Addri(Hfm) derived from the syndromes Si, a correction information Ci indicating "non correctable error" is inserted. Preferably, in rows placed at addresses in which more syndromes Si collide when the hash function Hfm is applied, one of the colliding syndromes Si is inserted (with its respective correction information Ci), after verification that the other colliding syndrome(s) Si is(are) already covered by other hash functions of the set of M hash functions. For instance, in the above example of GFP-T, each row of the error correction tables ECTm may have 26 bits: 16 bits are used for storing the syndromes Si, while the remaining 10 bits are used for storing the correction information Ci.

By referring again to Figure 2, the operation of the error corrector EC will be described in detail.

As mentioned above, the error corrector EC receives the syndrome S(x) from the syndrome evaluator SEV and the recovered codeword V' from the switch SW. Upon reception of the syndrome S(x), the control logic CL preferably instructs the M address calculators Hm to calculate M addresses Addrm (m=1, 2, ... M) by applying the hash functions Hfm to the syndrome S(x). Each address Addrm is then used for reading the syndrome Si stored at the address Addri(Hfm)=Addrm in the respective error correction table ECTm. The syndrome Si read from each table ECTm at the address Addri(Hfm)=Addrm is indicated as Sm in Figure 2. Then, the syndrome comparator SC preferably compares the M read syndromes Sm with the syndrome S(x). It has to be noticed that, if the received syndrome S(x) is indicative of a correctable error pattern Ei (i.e. it is equal to one of the syndromes Si), due to the above disclosed criteria for building the error correction tables ECTm, one of the M read syndromes Sm is necessarily equal to the syndrome S(x). Assuming that, for instance, the read syndrome Sm* is equal to the syndrome S(x), the control logic CL preferably instructs the correction block CB to read the correction information Ci stored in the error correction table ECTm* at the address Addri(Hfm*)=Addrm* (indicated as Cm* in Figure 2). The correction block CB then uses the correction information Cm* for correcting the recovered codeword V', thus deriving the original codeword V, that is forwarded to the sequence extractor SE. Otherwise, if none of the read syndromes Sm is equal to the received syndrome S(x), the control logic CL preferably issues a "non correctable error" indication.

The above error corrector EC advantageously requires a very reduced amount of memory.

Indeed, after the syndromes Si have been computed, in principle it would be possible to create a table where, in the memory location having address equal to the coefficients of the syndrome Si, the corresponding correction information Ci are stored. When the recovered codeword V' is received, the syndrome S(x) is calculated and its coefficients are used for looking up the table and retrieving the corresponding correction information. For instance, with reference to the above example of GFP-T protocol, the syndrome has 16 coefficients, i.e. the sequence of the syndrome coefficients may assume $2^{16}$=65536 different values. The table should therefore have 65536 memory locations. However, only 580 correctable error patterns Ei have been identified, i.e. a number much smaller than the number of memory locations available in the table. Therefore, 65536-580 memory locations with address other than the 580 syndromes generated by the 580 correctable error patterns are useless.

On the contrary, in the error corrector EC described above, the overall number of memory locations (i.e. rows) of the M error correction tables ECTm is much lower than the number of possible values that the sequence of syndrome coefficients may assume. Indeed, since the size of each error correction table ECTm is $2^{n'}$, the overall size of the M error correction tables ECTm is $M \times 2^{n'}$. In the above example of GFP-T protocol, if n' is equal to 10 and M is equal to 4, the overall size of the error correction tables ECTm is $4 \times 2^{10}$=4096. The number of memory locations is therefore reduced from 65536 to 4096. The higher is the difference between $2^{n-k}$ (i.e. the number of possible values of the syndrome) and N (i.e. the number of correctable error patterns Ei), the more consistent is the reduction of memory locations.

Comparing the syndromes advantageously allows avoiding collisions possibly generated using the hash functions.

The Applicant has performed several tests and has found that different sets with different numbers M of hash functions Hfm may be used, requiring the same number of memory locations. Indeed, the total amount of memory locations of the M error correction tables ECTm is $Mx2^{n'}$. Exemplary values for M and n' have been given above (M=4 and n'=10). If n' is increased (i.e. the length in bit of the addresses is increased), the number of collisions is reduced, and the number M of required hash functions is accordingly reduced. Therefore, while the number of memory locations of a single error correction table ECTm is increased, the number of error correction tables ECTm is reduced, thereby allowing keeping the overall number of memory locations substantially constant.

Moreover, the above error corrector EC is advantageously capable of detecting and correcting errors also when the codeword V is scrambled before transmission over the link L. Indeed, scrambling destroys the mathematical properties of the codeword V. However, since the error corrector EC does not make use of the mathematical properties of the codewords, scrambling advantageously does not affect the effectiveness of the error corrector EC.

The error corrector EC may be implemented either according to a parallel scheme or according to a serial scheme.

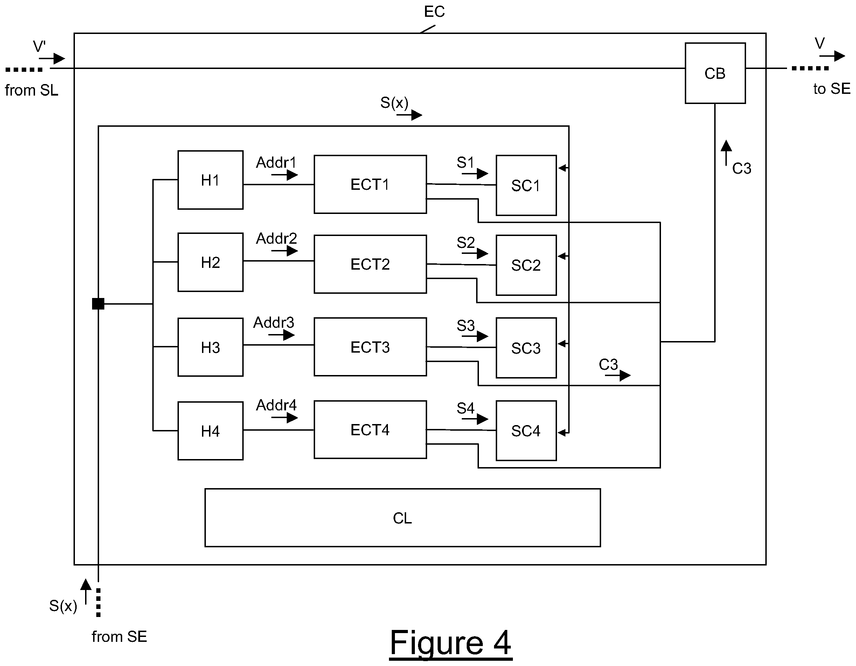

Figure 4 shows a preferred parallel implementation of the error corrector EC of Figure 2, under the assumption that M is equal to four. Accordingly, the error corrector EC comprises four address calculators H1, H2, H3, H4, four error correction tables ECT1, ECT2, ECT3, ECT4, a correction block CB and a control logic CL. Instead of the single syndrome comparator SC shown in Figure 2, the error corrector of Figure 4 preferably comprises four syndrome comparators SC1, SC2, SC3 and SC4 configured to work in parallel. Each of the four error correction tables ECT1, ECT2, ECT3, ECT4 is built as disclosed above, by applying a respective hash function Hf1, Hf2, Hf3, Hf4 to the syndromes Si corresponding to the correctable error patterns Ei. The hash functions Hf1, Hf2, Hf3, Hf4 are preferably selected so that the maximum number of collisions between the syndromes Si is four.

Upon reception of a syndrome S(x) from the syndrome evaluator SEV, the control logic CL preferably instructs the address calculators H1, H2, H3, H4 to calculate respective addresses Addr1, Addr2, Addr3, Addr4 by applying a respective hash function Hf1, Hf2, Hf3, Hf4 to the syndrome S(x). Each address Addr1, Addr2, Addr3, Addr4 is then used for reading the syndromes stored at the address Addr1, Addr2, Addr3, Addr4 in the respective error correction table ECT1, ECT2, ECT3, ECT4. Such read syndromes are indicated in Figure 4 as S1, S2, S3 and S4. Then, each syndrome comparator SC1, SC2, SC3, SC4 preferably compares the read syndrome S1, S2, S3, S4 with the syndrome S(x). As mentioned above, if the received syndrome S(x) is indicative of a correctable error pattern (i.e. it is equal to one of the syndromes Si), due to the above disclosed criteria for building the error correction tables ECT1, ECT2, ECT3, ECT4, one of the read syndromes S1, S2, S3, S4 is necessarily equal to the syndrome S(x). Each syndrome comparator SC1, SC2, SC3, SC4 preferably sends to the control logic CL a feedback with the result of the comparison. Assuming that, for instance, the read syndrome S3 is equal to the syndrome S(x), upon reception of a positive feedback from the syndrome comparator SC3 the control logic CL preferably instructs the correction block CB to read the correction information Ci stored in the error correction table ECT3 at the address Addr3 (indicated as C3 in Figure 4). The correction block CB then uses the correction information C3 for correcting the recovered codeword V', thus deriving the original codeword V, that is forwarded to the sequence extractor SE. Otherwise, if none of the syndromes S1, S2, S3 and S4 is equal to the syndrome S(x), the control logic CL preferably issues a "non correctable error" indication.

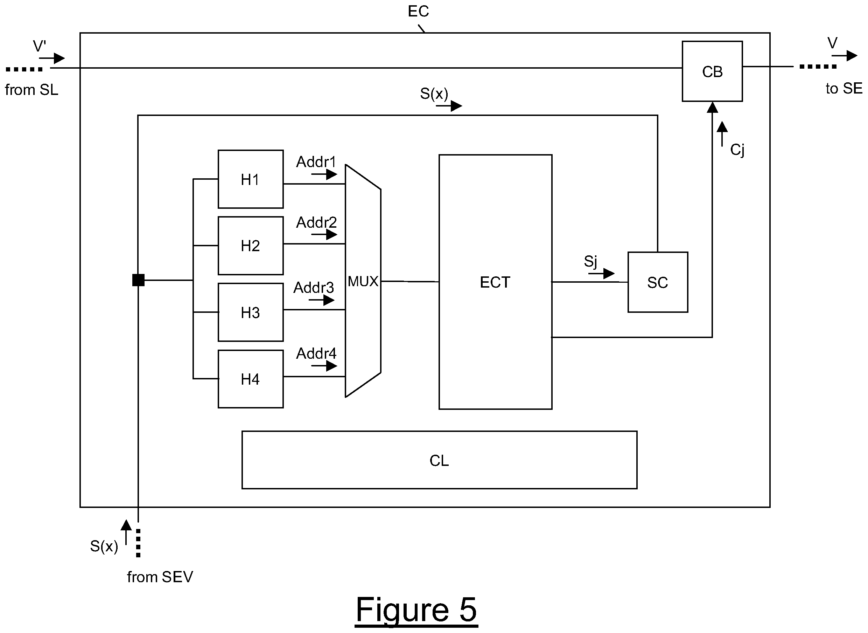

Figure 5 shows a preferred serial implementation of the error corrector EC of Figure 2, under the assumption that M is equal to four. Accordingly, the error corrector EC comprises four address calculators H1, H2, H3, H4, a control logic CL, a time multiplexer MUX, a syndrome comparator SC and a correction block CB. According to this serial implementation, the M error correction tables ECTm (m=1, 2, ... M) are preferably replaced by a single error correction table ECT. The error correction table ECT is preferably built starting from four hash functions Hf1, Hf2, Hf3, Hf4, that are preferably selected so that the maximum number of collisions between the syndromes Si is four.

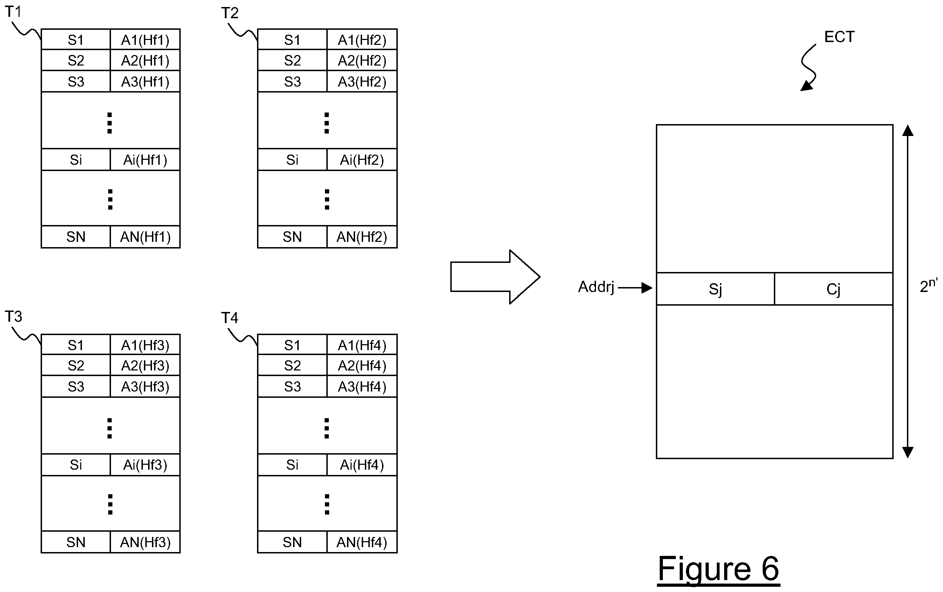

An exemplary process for building the error correction table ECT is shown in Figure 6. Each hash function Hf1, Hf2, Hf3 and Hf4 is applied to all the syndromes Si, and a respective table T1, T2, T3 and T4 of N rows is compiled for each hash function Hf1, Hf2, Hf3 and Hf4. In table T1, each row stores a syndrome Si and the respective address Ai(Hf1) calculated applying the hash function Hf1. In table T2, each row stores a syndrome Si and the respective address Ai(Hf2) calculated applying the hash function Hf2. In table T3, each row stores a syndrome Si and the respective address Ai(Hf3) calculated applying the hash function Hf3. Finally, in table T4, each row stores a syndrome Si and the respective address Ai(Hf4) calculated applying the hash function Hf4. Then, the collisions contained in the tables T1, T2, T3 and T4 are analyzed and, from the tables T1, T2, T3 and T4, the error correction table ECT of $2^{n'}$ rows is derived. The error correction table ECT may be empirically built starting from the tables T1, T2, T3, T4 in such a way that a row placed at an address Addrj (j=1, 2, ..., N) stores:

- one of the syndromes Si (indicated in Figure 6 as Sj) that generated that address Addrj according to anyone of the hash functions Hf1, Hf2, Hf3 and Hf4; and
- correction information Cj suitable for allowing correction of one of the correctable error patterns Ei (indicated in Figure 6 as Ej) that generated that syndrome Sj according to the generator polynomial G(x).

The content of each row is selected so as to avoid collisions. For instance, if in table T1 the syndromes S1 and S50 collide, i.e. A1(Hf1)=A50(Hf1), in the error correction table ECT at the row corresponding to address Addrj=A1(Hf1)=A50(Hf1) the syndrome S1 with the respective correction information C1 is stored. As to the syndrome S50 with the respective correction information C50, it will be stored in the error correction table ECT at a row corresponding to an address Addrj' calculated with another hash function, for instance at Addrj'=A50(Hf2). An so on. Rows at addresses that do not correspond to any of the syndromes Si are preferably filled with a correction information Ci indicating "non correctable error".

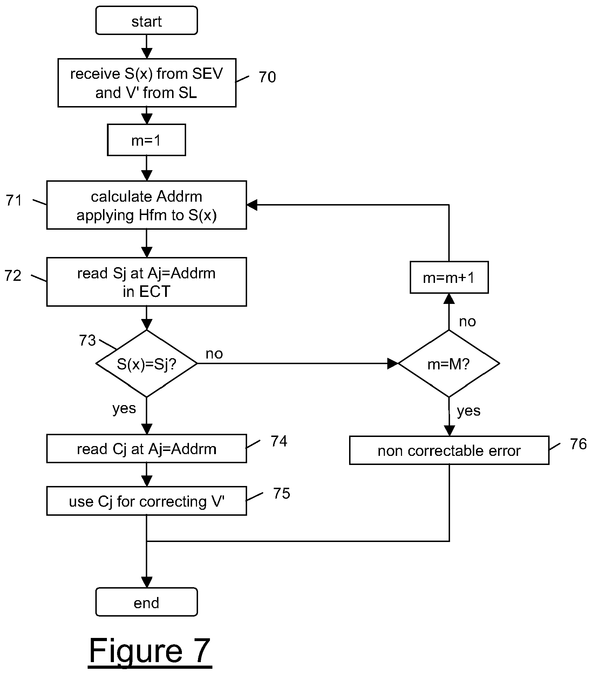

By referring again to Figure 5 and to the flow chart of Figure 7, the operation of the error corrector EC according to the preferred serial implementation will be described in detail.

As mentioned above, the error corrector EC receives the syndrome S(x) from the syndrome evaluator SEV and the recovered codeword V' from the switch SW (step 70).

During a step 71, the control logic CL preferably instructs the address calculator H1 to calculate an address Addr1 by applying the hash function Hf1 to the syndrome S(x) (step 71). Then, the first address Addr1 is used for reading the syndrome Sj stored at the row corresponding to the address Addrj=Addr1 in the error correction table ECT (step 72). The read syndrome Sj is then forwarded to the syndrome comparator SC, that preferably compares it with the syndrome S(x) received from the syndrome evaluator SEV (step 73).

If the syndrome comparator SC determines that the read syndrome Sj is equal to the syndrome S(x), it determines that the address Addrj at which the syndrome Sj has been read actually was calculated applying the hash function Hf1 to the syndrome Sj, and that accordingly the error pattern affecting the recovered codeword V' is the error pattern Ej stored at the address Addrj. The comparator CL then provides a positive feedback to the control logic CL, that preferably instructs the correction block CB to read the correction information Cj in the error correction table ECT at the address Addrj=Addr1 (step 74). The correction block CB than uses the correction information Cj for correcting the recovered codeword V' (step 75), thus deriving the original codeword V, that is forwarded to the sequence extractor SE.

Otherwise, if the syndrome comparator SC determines that the read syndrome Sj is different from the syndrome S(x), it determines that the address Addrj at which the syndrome Sj has been read was calculated applying an hash function different from Hf1 to the syndrome Sj, and that accordingly the error pattern affecting the recovered codeword V' is not the error pattern Ej stored at the address Addrj. The syndrome comparator SC then provides a negative feedback to the control logic CL, that preferably instructs the address calculator H2 to calculate an address Addr2 by applying the hash function Hf2 to the syndrome S(x) (step 71). Steps 72 (reading the syndrome Sj) and 73 (comparing the read syndrome Sj with the syndrome S(x)) are then repeated.

If the syndrome comparator SC determines that the read syndrome Sj is equal to the syndrome S(x), steps 74 and 75 are performed, thus leading to correction of the recovered codeword V'. Otherwise, the syndrome comparator SC provides a negative feedback to the control logic CL, that preferably instructs the address calculator H3 to calculate an address Addr3 by applying the hash function Hf3 to the syndrome S(x) (step 71). Steps 72 and 73 are then repeated. And so on.

Therefore, according to this parallel implementation, steps 71, 72 and 73 are cyclically repeated until a matching is found between the syndrome S(x) and the syndrome Sj read from the error correction table ECT at the address Addrj=Addrm. In can be noticed that, if the received syndrome S(x) is indicative of a correctable error pattern (i.e. it is equal to one of the syndromes Si), a matching is necessarily found within M repetitions of steps 71, 72, 73, since the error correction table ECT has been construed *ad hoc,* as explained above. Otherwise, if a matching is not found within M repetitions of steps 71, 72 and 73, the control logic CL preferably issues a "non correctable error" indication (step 76).

The above described parallel and serial implementation of the error corrector EC have a number of advantages.

First of all, they are both very easy and compact. Moreover, they are very fast, so that they may be easily applied also at very high transmission bit rates, such as for instance 100 Gbps or more.

As to the parallel implementation, is particularly advantageous when time constraints are very tight, since it requires a fixed and very reduced number of clock cycles, i.e.: a clock cycle for calculating the addresses Addr1, Addr2, Addr3, Addr4, a clock cycle for reading the syndromes S1, S2, S3, S4 in the error correction tables ECTm, and a clock cycle for comparing the read syndromes S1, S2, S3, S4 with the syndrome S(x). In the parallel implementation, therefore, assuming that the syndrome calculation time and the error correction time are much smaller than a frame period, only three clock cycles are advantageously required for correcting possible errors in the recovered codeword V'. This is independent of the maximum number M of collisions.

On the other hand, if time constraints are not very tight, the serial implementation may be adopted. The number maximum number of required clock cycles is three (one for calculating the address Addrm, one for reading the syndromes Sj in the error correction table ECT and one for comparing the read syndromes Sj with the syndrome S(x)) multiplied by M (i.e. the maximum number of collisions). In the above example, where M is equal to four, a maximum number of twelve clock cycles is then requires. This number may be reduced e.g. by reducing the maximum number M of collisions, since this would reduce the maximum number of required accesses to the error correction table ECT. However, reducing the maximum number M of collisions requires increasing the length n' of the hash function's output, and therefore increasing the number of rows in the error correction table ECT. Therefore, according to the serial implementation, a trade-off exists between the maximum number of cycles required for correcting the recovered codeword V' and the size of the memory device storing the error correction table ECT.

**Claims**

1. A method for correcting one or more errors, introduced by transmission over a communications link (L), in original codewords (V) transmitted over the communications link (L) and received as recovered codewords (V') at a network element (RX) of a communication network (CN), the network element (RX) having a syndrome evaluator (SEV) providing a first syndrome (Sx) dependent upon an error pattern introduced by the link (L) and a multiplicity of address calculators (Hm) each arranged to receive the first syndrome (Sx), said method comprising:

   before starting transmission of said codewords:

   a) at said network element (RX), storing a single error correction table (ECT), comprising N correction information (Ci) allowing to correct N correctable error patterns (Ei) possibly affecting said codewords, the error correction table built by applying a multiplicity of hash functions (Hfl-Hf4) to all syndromes (Si) and compiling, for each of the multiplicity of hash functions, a table in which each row stores a syndrome (Si) and its respective address (Ai(Hfm) is calculated applying a selected one of the multiplicity of hash functions and wherein the error correction table (ECT) is assembled from each of the tables (T1-T4) from collision analysis between each of the tables (T1-T4) such that each row, placed at a corresponding address in the error correction table, avoids collisions between different syndromes calculated using a common hash function and each row of the correction table stores (i) one of the syndromes (Si, Sj) that generated that address of the row according to any one of the multiplicity of hash functions and (ii) correction information (Cj) allowing correction of one of a multiplicity of correctable error patterns (Ei) that generated the syndrome (Si, Sj);

   upon reception of each recovered codeword (V') of said original codewords (V), at said network element (RX):

   b) calculating a syndrome (S(x)) of said each recovered codeword (V');
   c) for each of said multiplicity of address calculators (Hm), calculating an address (Addrm) by applying a respective hash function (Hfm) of the address calculator to said calculated syndrome (S(x)) of the recovered codeword (V');
   d) time-multiplexing the calculated addresses to generate an output, which result is applied to each of said M calculated addresses (Addrm) from each address calculator (Hm), using the respective address for reading a corresponding syndrome stored at a row corresponding to the address in the error correction table (ECT); and
   e) using each time-multiplexed address in the output to identify a corresponding syndrome (Si, Sj) in the error correction table, and forwarding the corresponding syndrome (Si, Sj) to a syndrome comparator (SC) arranged to compare the corresponding syndrome with the first syndrome;
   f) supplying the corresponding syndrome to a correction block (CB) further receptive to the recovered codeword (V');
   g) using said selected correction information (Cm*) for correcting one or more errors affecting said each recovered codeword (V') by having the syndrome comparator (SC):

      i) determine whether read syndrome (Si, Sj) is equal to the first syndrome (S(x)) and, if so, determining that the address (Addrj) at which the corresponding syndrome (Si, Sj) was read was calculated applying a first hash function (Hfl-Hf4) to the corresponding syndrome (Si, Sj) and identifying that a first error pattern affecting the recovered codeword (V') is the error pattern (Ej) stored at the corresponding address (Addrj) in the error correction table (ECT), whereafter the syndrome comparator (SC) provides a positive report causing the correction block CB to read the correction information (Cj) in the error correction table ECT at the address (Addrj) of the corresponding syndrome;
      ii) determine whether read syndrome (Si, Sj) is different from the first syndrome S(x) and, if so, determining that the address (Addrj) at which the corresponding syndrome (Si, Sj) was read was calculated applying a second hash function different to the first Hf1 to the corresponding syndrome (Si, Sj), and identifying the error pattern affecting the recovered codeword (V') is not the error pattern (Ej) stored at the corresponding address (Addrj), whereafter the syndrome comparator (SC) provides a negative report causing the correction block CB to cause the correction block CB to instruct a second different

9

address calculator (H2-H4) to calculate a second different address (Addr2) by applying its respective hash function (Hf2-Hf4) to the first syndrome S(x); and

iii) cyclically repeat evaluation of the respective hash functions until a match is found between the first syndrome S(x) and the corresponding syndrome (Si, Sj) read from the error correction table ECT at each corresponding address (Addrj), otherwise providing an indication that an error in the recovered codeword (V') is non-correctable after iteration through the multiplicity of hash functions of the address calculators (Hm).

2. The method according to claim 1, wherein in said step c) each of said M hash functions (Hfm) is such that each of said M calculated addresses (Addrm) has n' bits, n' being the smallest integer so that $2^{n'}$ is equal to or higher than N.

3. The method according to claim 1, wherein said step a) comprises storing, in each of said error correction table (ECT), at each table address other than said N table addresses of said respective set, a "non correctable error" information.

4. The method according to claim 1, wherein step d) further comprises:

d1) using said M calculated addresses (Addrm) for reading in the error correction table (ECT) M possible syndromes (Sm) stored at table addresses (Addri(Hfm)) equal to said M calculated addresses (Addrm);
d2) comparing said M read possible syndromes (Sm) with said calculated syndrome (S(x)) and;
d3) if one of said M read possible syndromes (Sm) is equal to said calculated syndrome (S(x)), reading, in the error correction table (ECTm) from which said one of said M read possible syndromes (Sm) has been read during step d1), the correction information (Cm*) stored at a table address (Addri(Hfm)) equal to the calculated address (Addrm) at which said one of said M read possible syndromes (Sm) has been read during step d1).

5. A computer program product comprising computer-executable instructions for performing, when the program is run on a computer of a network element (RX) of a communication network (CN), a method for correcting one or more errors in a codeword (V') received at said network element (RX), said method executing the steps of any of claims 1 to 4.

6. A digital data storage medium storing a computer program product according to claim 5.

7. A network element arranged to correct one or more errors, introduced by transmission over a communications link (L), in original codewords (V) transmitted over the communications link (L) and received as recovered codewords (V') at the network element (RX), the network element (RX) having:

a syndrome evaluator (SEV) providing a first syndrome (Sx) dependent upon an error pattern introduced by the link (L);
a multiplicity of address calculators (Hm) each arranged to receive the first syndrome (Sx);
an error correction table (ECT) receptive to time multiplexed addresses generated as outputs from each of the address calculators (Hm), wherein the error correction table (ECT) stores N correction information (Ci) allowing correction of N correctable error patterns (Ei) possibly affecting said codewords, the error correction table built by applying a multiplicity of hash functions (Hfl-Hf4) to all syndromes (Si) and compiling, for each of the multiplicity of hash functions, a table in which each row stores a syndrome (Si) and its respective address (Ai(Hfm) is calculated applying a selected one of the multiplicity of hash functions and wherein the error correction table (ECT) is assembled from each of the tables (T1-T4) from collision analysis between each of the tables (T1-T4) such that each row, placed at a corresponding address in the error correction table, avoids collisions between different syndromes calculated using a common hash function and each row of the correction table stores (i) one of the syndromes (Si, Sj) that generated that address of the row according to any one of the multiplicity of hash functions and (ii) correction information (Cj) allowing correction of one of a multiplicity of correctable error patterns (Ei) that generated the syndrome (Si, Sj);
wherein, upon reception of each recovered codeword (V') of said original codewords (V), the network element (RX) is arranged to:

a) calculate a syndrome (S(x)) of said each recovered codeword (V');
b) for each of said multiplicity of address calculators (Hm), calculate an address (Addrm) by applying a respective hash function (Hfm) of the address calculator to said calculated syndrome (S(x)) of the recovered codeword (V');

c) time-multiplex the calculated addresses to generate an output, which result is applied to each of said M calculated addresses (Addrm) from each address calculator (Hm), using the respective address for reading a corresponding syndrome stored at a row corresponding to the address in the error correction table (ECT); and

d) use each time-multiplexed address in the output to identify a corresponding syndrome (Si, Sj) in the error correction table, and forward the corresponding syndrome (Si, Sj) to a syndrome comparator (SC) arranged to compare the corresponding syndrome with the first syndrome;

e) supply the corresponding syndrome to a correction block (CB) further receptive to the recovered codeword (V');

f) use said selected correction information (Cm*) for correcting one or more errors affecting said each recovered codeword (V') by having the syndrome comparator (SC):

i) determine whether read syndrome (Si, Sj) is equal to the first syndrome (S(x)) and, if so, determine that the address (Addrj) at which the corresponding syndrome (Si, Sj) was read was calculated applying a first hash function (Hfl-Hf4) to the corresponding syndrome (Si, Sj) and identify that a first error pattern affecting the recovered codeword (V') is the error pattern (Ej) stored at the corresponding address (Addrj) in the error correction table (ECT), whereafter the syndrome comparator (SC) is arranged to provide a positive report causing the correction block CB to read the correction information (Cj) in the error correction table ECT at the address (Addrj) of the corresponding syndrome;

ii) determine whether read syndrome (Si, Sj) is different from the first syndrome S(x) and, if so, determine that the address (Addrj) at which the corresponding syndrome (Si, Sj) was read was calculated applying a second hash function different to the first Hfl to the corresponding syndrome (Si, Sj), and identify the error pattern affecting the recovered codeword (V') is not the error pattern (Ej) stored at the corresponding address (Addrj), whereafter the syndrome comparator (SC) is arranged to provide a negative report to causing the correction block CB to cause the correction block CB to instruct a second different address calculator (H2-H4) to calculate a second different address (Addr2) by applying its respective hash function (Hf2-Hf4) to the first syndrome S(x); and

iii) cyclically repeat evaluation of the respective hash functions until a match is found between the first syndrome S(x) and the corresponding syndrome (Si, Sj) read from the error correction table ECT at each corresponding address (Addrj), otherwise to provide an indication that an error in the recovered codeword (V') is non-correctable after iteration through the multiplicity of hash functions of the address calculators (Hm).

**Patentansprüche**

1. Verfahren zum Korrigieren von einem oder mehreren Fehlern, die durch Übertragung über eine Kommunikationsverbindung (L) eingeleitet werden, und zwar in ursprünglichen Codewörtern (V), die über die Kommunikationsverbindung (L) übertragen und als wiederhergestellte Codewörter (V') an einem Netzelement (RX) eines Kommunikationsnetzes (CN) empfangen werden, wobei das Netzelement (RX) einen Syndromauswerter (SEV), der ein erstes Syndrom (Sx) bereitstellt, das von einem durch die Verbindung (L) eingeführten Fehlermuster abhängt, und eine Vielzahl von Adressenberechnern (Hm) aufweist, die jeweils so angeordnet sind, dass sie das erste Syndrom (Sx) empfangen,

wobei das Verfahren folgende Schritte aufweist:

vor dem Beginn der Übertragung der Codewörter:

a) Speichern einer Einzel-Fehler-Korrekturtabelle (ECT) an dem Netzelement (RX), wobei die Einzel-Fehler-Korrekturtabelle (ECT) N Korrekturinformationen (Ci) aufweist, die es ermöglichen, N korrigierbare Fehlermuster (Ei) zu korrigieren, die möglicherweise die Codewörter beeinträchtigen, wobei die Fehler-Korrekturtabelle durch folgende Schritte aufgebaut wird: Anwenden einer Vielzahl von Hash-Funktionen (Hfl - Hf4) auf alle Syndrome (Si) und Kompilieren für jede der Vielzahl von Hash-Funktionen einer Tabelle, in der jede Zeile ein Syndrom (Si) speichert, und seine jeweilige Adresse (Ai(Hfm) durch Anwenden einer ausgewählten Funktion der Vielzahl von Hash-Funktionen berechnet wird, und wobei die Fehler-Korrekturtabelle (ECT) aus jeder der Tabellen (T1-T4) aus einer Kollisionsanalyse zwischen jeder der Tabellen (T1-T4) so zusammengestellt wird, dass jede Zeile, die an einer entsprechenden Adresse in der Fehler-Korrekturtabelle angeordnet ist, Kollisionen zwischen unterschiedlichen Syndromen vermeidet, die unter Verwendung einer gemeinsamen Hash-Funktion berechnet worden sind, und wobei jede Zeile der Korrekturtabelle folgende Daten speichert: (i) eines der Syndrome (Si, Sj), das diese Adresse der Zeile gemäß einer der Vielzahl von Hash-Funktionen erzeugt hat, und (ii) Korrekturinformationen (Cj), die eine Korrektur von einem von einer Vielzahl von korrigierbaren Fehlermustern (Ei) ermöglichen, die das Syndrom (Si, Si) erzeugt haben;

beim Empfang von jedem wiederhergestellten Codewort (V') der ursprünglichen Codewörter (V) an dem Netzelement (RX):

b) Berechnen eines Syndroms (S(x)) von jedem wiederhergestellten Codewort (V');

c) für jeden von der Vielzahl von Adressenberechnern (Hm), Berechnen einer Adresse (Addrm) durch Anwenden einer entsprechenden Hash-Funktion (Hfm) des Adressenberechners auf das berechnete Syndrom (S(x)) des wiederhergestellten Codeworts (V');

d) Zeitmultiplexen der berechneten Adressen, um eine Ausgabe zu erzeugen, wobei das Ergebnis auf jede von den M berechneten Adressen (Addrm) von jedem Adressenberechner (Hm) angewendet wird, und zwar unter Verwendung der jeweiligen Adresse zum Lesen eines entsprechenden Syndroms, das in der Zeile gespeichert ist, die der Adresse in der Fehler-Korrekturtabelle (ECT) entspricht; und

e) Verwenden jeder zeitmultiplexierten Adresse in der Ausgabe, um ein entsprechendes Syndrom (Si, Sj) in der Fehler-Korrekturtabelle zu ermitteln, und Weiterleiten des entsprechenden Syndroms (Si, Sj) an einen Syndromvergleicher (SC), der dazu ausgelegt ist, das entsprechende Syndrom mit dem ersten Syndrom zu vergleichen;

f) Zuführen des entsprechenden Syndroms zu einem Korrekturblock (CB), der ferner empfangsfähig für das wiederhergestellte Codewort (V') ist;

g) Verwenden der ausgewählten Korrekturinformation (Cm*) zum Korrigieren von einem oder mehreren Fehlern, die das jeweils wiederhergestellte Codewort (V') beeinträchtigen, und zwar mittels des Syndromvergleichers (SC):

i) Bestimmen, ob das gelesene Syndrom (Si, Sj) gleich dem ersten Syndrom (S(x)) ist, und, wenn ja, Bestimmen, dass die Adresse (Addrj), an der das entsprechende Syndrom (Si, Sj) gelesen worden ist, dadurch berechnet worden ist, dass eine erste Hash-Funktion (Hfl - Hf4) auf das entsprechende Syndrom (Si, Sj) angewendet worden ist, und Ermitteln, dass ein erstes Fehlermuster, das das wiederhergestellte Codewort (V') beeinträchtigt, das Fehlermuster (Ej) ist, das an der entsprechenden Adresse (Addrj) in der Fehler-Korrekturtabelle (ECT) gespeichert ist, woraufhin der Syndromvergleicher (SC) einen positiven Bericht liefert, der den Korrekturblock (CB) veranlasst, die Korrekturinformationen (Cj) in der Fehler-Korrekturtabelle (ECT) an der Adresse (Addrj) des entsprechenden Syndroms zu lesen;

ii) Bestimmen, ob sich das gelesene Syndrom (Si, Sj) von dem ersten Syndrom S(x) unterscheidet, und, wenn ja, Bestimmen, dass die Adresse (Addrj), an der das entsprechende Syndrom (Si, Sj) gelesen worden ist, dadurch berechnet worden ist, dass eine zweite Hash-Funktion, die sich von der ersten Hfl unterscheidet, auf das entsprechende Syndrom (Si, Sj) angewendet worden ist, und Ermitteln, dass das Fehlermuster, das das wiederhergestellte Codewort (V') beeinträchtigt, nicht das Fehlermuster (Ej) ist, das an der entsprechenden Adresse (Addrj) gespeichert ist, woraufhin der Syndromvergleicher (SC) einen negativen Bericht liefert, der den Korrekturblock (CB) veranlasst, den Korrekturblock (CB) dazu zu veranlassen, einen zweiten anderen Adressenberechner (H2-H4) anzuweisen, eine zweite andere Adresse (Addr2) zu berechnen, und zwar durch das Anwenden seiner jeweiligen Hash-Funktion (Hf2-Hf4) auf das erste Syndrom S(x); und

iii) zyklisch wiederholte Auswertung der jeweiligen Hash-Funktionen, bis eine Übereinstimmung zwischen dem ersten Syndrom S(x) und dem aus der Fehler-Korrekturtabelle ECT gelesenen entsprechenden Syndrom (Si, Sj) an jeder entsprechenden Adresse (Addrj) gefunden wird, ansonsten Liefern eines Hinweises darauf, dass ein Fehler in dem wiederhergestellten Codewort (V') nach der Iteration durch die Vielzahl von Hash-Funktionen der Adressenberechner (Hm) nicht korrigierbar ist.

2. Verfahren nach Anspruch 1,
wobei in dem Schritt c) jede der M Hashfunktionen (Hfm) so ausgebildet ist, dass jede der M berechneten Adressen (Addrm) n' Bits aufweist, wobei n' die kleinste ganze Zahl ist, so dass $2^{n'}$ gleich dem Wert von oder größer als N ist.

3. Verfahren nach Anspruch 1,
wobei der Schritt a) das Speichern einer "nicht korrigierbarer Fehler"-Information in jeder der Fehler-Korrekturtabelle (ECT) an jeder Tabellenadresse aufweist, die von den N Tabellenadressen der jeweiligen Menge verschieden ist.

**4.** Verfahren nach Anspruch 1,
wobei der Schritt d) ferner folgende Schritte aufweist:

dl) Verwenden der M berechneten Adressen (Addrm) zum Lesen von M möglichen Syndromen (Sm) in der Fehler-Korrekturtabelle (ECT), die an Tabellenadressen (Addri(Hfm)) gespeichert sind, die gleich den M berechneten Adressen (Addrm) sind;
d2) Vergleichen der M gelesenen möglichen Syndrome (Sm) mit dem berechneten Syndrom (S(x)) und;
d3) wenn eines der M gelesenen, möglichen Syndrome (Sm) gleich dem berechneten Syndrom (S(x)) ist, Lesen in der Fehler-Korrekturtabelle (ECTm), aus der das eine der M gelesenen möglichen Syndrome (Sm) während Schritt dl) gelesen worden ist, von Korrekturinformationen (Cm*), die an einer Tabellenadresse (Addri(Hfm)) gespeichert sind, die gleich der berechneten Adresse (Addrm) ist, an der das eine der M gelesenen möglichen Syndrome (Sm) gelesen worden ist.

**5.** Computerprogrammprodukt, das computerausführbare Anweisungen zum Ausführen, und zwar wenn das Programm auf einem Computer eines Netzelements (RX) eines Kommunikationsnetzwerks (CN) ausgeführt wird, eines Verfahrens zum Korrigieren von einem oder mehreren Fehlern in einem Codewort (V'), das an dem Netzelement (rX) empfangen wird, wobei das Verfahren die Schritte gemäß einem der Ansprüche 1 bis 4 ausführt.

**6.** Digitales Datenspeichermedium,
das ein Computerprogrammprodukt nach Anspruch 5 speichert.

**7.** Netzwerkelement, das dazu ausgelegt ist, einen oder mehrere Fehler zu korrigieren, die durch Übertragung über eine Kommunikationsverbindung (L) eingeleitet werden, und zwar in ursprünglichen Codewörtern (V), die über die Kommunikationsverbindung (L) übertragen und als wiederhergestellte Codewörter (V') an dem Netzelement (RX) empfangen werden, wobei das Netzelement (RX) Folgendes aufweist:

- einen Syndromauswerter (SEV), der ein erstes Syndrom (Sx) bereitstellt, das von einem durch die Verbindung (L) eingeführten Fehlermuster abhängt,
- eine Vielzahl von Adressenberechnern (Hm), die jeweils dazu ausgelegt sind, dass sie das erste Syndrom (Sx) empfangen;
- eine Fehler-Korrekturtabelle (ECT), die empfangsfähig für zeitmultiplexierte Adressen ist, die als Ausgaben von jedem der Adressenberechner (Hm) erzeugt werden, wobei die Fehler-Korrekturtabelle (ECT) N Korrekturinformationen (Ci) speichert, die die Korrektur von N korrigierbaren Fehlermustern (Ei) ermöglichen, die möglicherweise die Codewörter beeinträchtigen, wobei die Fehler-Korrekturtabelle durch folgende Schritte aufgebaut wird: Anwenden einer Vielzahl von Hash-Funktionen (Hf1 - Hf4) auf alle Syndrome (Si) und Kompilieren für jede von der Vielzahl von Hash-Funktionen einer Tabelle, in der jede Zeile ein Syndrom (Si) speichert, und seine jeweilige Adresse (Ai(Hfm) durch Anwenden einer ausgewählten Funktion der Vielzahl von Hash-Funktionen berechnet wird, und wobei die Fehler-Korrekturtabelle (ECT) aus jeder der Tabellen (T1-T4) aus einer Kollisionsanalyse zwischen jeder der Tabellen (T1-T4) so zusammengestellt wird, dass jede Zeile, die an einer entsprechenden Adresse in der Fehler-Korrekturtabelle angeordnet ist, Kollisionen zwischen unterschiedlichen Syndromen vermeidet, die unter Verwendung einer gemeinsamen Hash-Funktion berechnet worden sind, und wobei jede Zeile der Korrekturtabelle folgende Daten speichert: (i) eines der Syndrome (Si, Sj), das diese Adresse der Zeile gemäß einer der Vielzahl von Hash-Funktionen erzeugt hat, und (ii) Korrekturinformationen (Cj), die eine Korrektur von einem von einer Vielzahl von korrigierbaren Fehlermustern (Ei) ermöglichen, die das Syndrom (Si, Si) erzeugt haben;
wobei beim Empfang von jedem wiederhergestellten Codewort (V') der ursprünglichen Codewörter (V) das Netzelement (RX) für Folgendes ausgelegt ist:

a) ein Syndrom (S(x)) von jedem wiederhergestellten Codewort (V') zu berechnen;
b) für jeden von der Vielzahl von Adressenberechnern (Hm) eine Adresse (Addrm) zu berechnen , und zwar durch Anwenden einer entsprechenden Hash-Funktion (Hfm) des Adressenberechners auf das berechnete Syndrom (S(x)) des wiederhergestellten Codeworts (V');
c) die berechneten Adressen zu zeitmultiplexen, um eine Ausgabe zu erzeugen, wobei das Ergebnis auf jede der M berechneten Adressen (Addrm) von jedem Adressenberechner (Hm) angewendet wird, und zwar unter Verwendung der jeweiligen Adresse zum Lesen eines entsprechenden Syndroms, das in der Zeile gespeichert ist, die der Adresse in der Fehler-Korrekturtabelle (ECT) entspricht; und
d) jede zeitmultiplexierte Adresse in der Ausgabe zu verwenden, um ein entsprechendes Syndrom (Si, Sj) in der Fehler-Korrekturtabelle zu ermitteln, und das entsprechenden Syndrom (Si, Sj) an einen Syndromvergleicher (SC) weiterzuleiten, der dazu ausgelegt ist, das entsprechende Syndrom mit dem ersten Syndrom zu vergleichen;

e) das entsprechende Syndrom einem Korrekturblock (CB) zuzuführen, der ferner empfangsfähig für das wiederhergestellte Codewort (V') ist;

f) die ausgewählte Korrekturinformation (Cm*) zum Korrigieren von einem oder mehreren Fehlern zu verwenden, die das jeweils wiederhergestellte Codewort (V') beeinträchtigen, und zwar mittels des Syndromvergleichers (SC):

i) zu bestimmen, ob das gelesene Syndrom (Si, Sj) gleich dem ersten Syndrom (S(x)) ist, und, wenn ja, zu bestimmen, dass die Adresse (Addrj), an der das entsprechende Syndrom (Si, Sj) gelesen worden ist, dadurch berechnet worden ist, dass eine erste Hash-Funktion (Hf1 - Hf4) auf das entsprechende Syndrom (Si, Sj) angewendet worden ist, und zu ermitteln, dass ein erstes Fehlermuster, das das wiederhergestellte Codewort (V') beeinträchtigt, das Fehlermuster (Ej) ist, das an der entsprechenden Adresse (Addrj) in der Fehler-Korrekturtabelle (ECT) gespeichert ist, woraufhin der Syndromvergleicher (SC) dazu ausgelegt ist, einen positiven Bericht zu liefern, der den Korrekturblock (CB) veranlasst, die Korrekturinformationen (Cj) in der Fehler-Korrekturtabelle (ECT) an der Adresse (Addrj) des entsprechenden Syndroms zu lesen;

ii) zu bestimmen, ob sich das gelesene Syndrom (Si, Sj) von dem ersten Syndrom S(x) unterscheidet, und, wenn ja, zu bestimmen, dass die Adresse (Addrj), an der das entsprechende Syndrom (Si, Sj) gelesen worden ist, dadurch berechnet worden ist, dass eine zweite Hash-Funktion, die sich von der ersten Hfl unterscheidet, auf das entsprechende Syndrom (Si, Sj) angewendet worden ist, und zu ermitteln, dass das Fehlermuster, das das wiederhergestellte Codewort (V') beeinträchtigt, nicht das Fehlermuster (Ej) ist, das an der entsprechenden Adresse (Addrj) gespeichert ist, woraufhin der Syndromvergleicher (SC) dazu ausgelegt ist, einen negativen Bericht zu liefern, um den Korrekturblock (CB) zu veranlassen, den Korrekturblock (CB) dazu zu veranlassen, einen zweiten anderen Adressenberechner (H2-H4) anzuweisen, eine zweite andere Adresse (Addr2) zu berechnen, und zwar durch Anwenden seiner jeweiligen Hash-Funktion (Hf2-Hf4) auf das erste Syndrom S(x); und

iii) zyklisch wiederholte Auswertung der jeweiligen Hash-Funktionen, bis eine Übereinstimmung zwischen dem ersten Syndrom S(x) und dem aus der Fehler-Korrekturtabelle ECT gelesenen entsprechenden Syndrom (Si, Sj) an jeder entsprechenden Adresse (Addrj) gefunden wird, ansonsten Liefern eines Hinweises darauf, dass ein Fehler in dem wiederhergestellten Codewort (V') nach der Iteration durch die Vielzahl von Hash-Funktionen der Adressenberechner (Hm) nicht korrigierbar ist.

## Revendications

1. Procédé de correction d'une ou plusieurs erreurs, introduites lors d'une transmission via une liaison de communication (L), dans des mots de code d'origine (V) transmis via la liaison de communication (L) et reçus sous forme de mots de code récupérés (V') au niveau d'un élément réseau (RX) d'un réseau de communication (CN), l'élément réseau (RX) présentant un évaluateur de syndrome (SEV) fournissant un premier syndrome (Sx) dépendant d'un motif d'erreurs introduit par la liaison (L) et une multiplicité de calculateurs d'adresse (Hm), chacun étant configuré pour recevoir le premier syndrome (Sx), ledit procédé comprenant :

avant de débuter la transmission des mots de code :

(a) au niveau dudit élément réseau (RX), le stockage d'une table de correction d'erreur unique (ECT), comprenant N informations de correction (Ci) permettant de corriger N motifs d'erreur corrigibles (Ei) pouvant affecter lesdits mots de code, la table de correction d'erreur étant construite en appliquant une multiplicité de fonctions de hachage (Hf1-Hf4) à tous les syndromes (Si) et la compilation, pour chacune de la multiplicité de fonctions de hachage, d'une table dans laquelle chaque rangée stocke un syndrome (Si), et son adresse respective (Ai(Hfm) est calculée en appliquant une fonction choisie parmi la multiplicité de fonctions de hachage et selon lequel la table de correction d'erreur (ECT) est assemblée à partir de chacune des tables (T1-T4) par le biais d'une analyse des collisions entre chacune des tables (T1-T4) de sorte que chaque rangée, placée à une adresse correspondante dans la table de correction d'erreur, évite des collisions entre différents syndromes calculées via une fonction de hachage commune et chaque rangée de la table de correction stocke (i) l'un des syndromes (Si, Sj) ayant généré cette adresse de la rangée selon l'une quelconque de la multiplicité des fonctions de hachage et (ii) des informations de correction (Cj) permettant la correction d'un parmi une multiplicité de motifs d'erreur corrigibles (Ei) ayant généré le syndrome (Si, Sj) ;

lors de la réception de chaque mot de code récupéré (V') des mots de code d'origine (V), au niveau de l'élément réseau (RX) :

(b) le calcul d'un syndrome (S(x)) de chacun desdits mots de code récupérés (V') ;

(c) pour chacun de ladite multiplicité de calculateurs d'adresse (Hm), le calcul d'une adresse (Addrm) en appliquant une fonction de hachage respective (Hfm) du calculateur d'adresse audit syndrome calculé (S(x)) du mot de code récupéré (V') ;

(d) le multiplexage temporel des adresses calculées afin de générer une sortie, dont le résultat est appliqué à chacune des M adresses calculées (Addrm) en provenance de chaque calculateur d'adresse (Hm), mettant en œuvre l'adresse respective pour la lecture d'un syndrome correspondant stocké dans une rangée correspondant à l'adresse dans la table de correction d'erreur (ECT) ; et

(e) l'utilisation de chaque adresse de multiplexage temporel dans la sortie afin d'identifier un syndrome correspondant (Si, Sj) dans la table de correction d'erreur, et la retransmission du syndrome correspondant (Si, Sj) à un comparateur de syndrome (SC) configuré pour comparer le syndrome correspondant avec le premier syndrome ;

(f) la fourniture du syndrome correspondant à un bloc de correction (CB) qui est en outre susceptible de recevoir le mot de code récupéré (V') ;

(g) l'utilisation des dites informations de correction choisies (Cm*) afin de corriger une ou plusieurs erreurs affectant chacun des dits mots de code récupérés (V!) en faisant en sorte que le comparateur de syndrome (SC) :

(i) détermine si le syndrome de lecture (Si, Sj) est égal au premier syndrome (S(x)) et, dans l'affirmatif, déterminer que l'adresse (Addrj), au niveau de laquelle le syndrome correspondant (Si, Sj) a été lue, a été calculée en appliquant une première fonction de hachage (Hf1-Hf4) au syndrome correspondant (Si, Sj) et en identifiant qu'un premier motif d'erreur affectant le mot de code récupéré (V') est le motif d'erreur (Ej) stocké au niveau de l'adresse correspondante (Addrj) dans la table de correction d'erreur (ECT), après quoi le comparateur de syndrome (SC) fournit un rapport positif ayant pour effet que le bloc de correction (CB) lit les informations de correction (Cj) dans la table de correction d'erreur (ECT) au niveau de l'adresse (Addrj) du syndrome correspondant ;

(ii) détermine si le syndrome de lecture (Si, Sj) est différent du premier syndrome (S(x)) et dans l'affirmatif, détermine que l'adresse (Addrj) au niveau de laquelle le syndrome correspondant (Si, Sj) a été lue, a été calculée en appliquant une seconde fonction de hachage différente de la première fonction de hachage (Hf1) au syndrome correspondant (Si, Sj), et en identifiant que le motif d'erreur affectant le mot de code récupéré (V') n'est pas le motif d'erreur (Ej) stocké au niveau de l'adresse correspondante (Addrj), après quoi le comparateur de syndrome (SC) fournit un rapport négatif ayant pour effet que le bloc de correction (CB) ordonne à un second calculateur d'adresse différent (H2-H4) de calculer une seconde adresse différente (Addr2) en appliquant sa fonction de hachage respective (Hf2-Hf4) au premier syndrome S(x) ; et

(iii) l'évaluation répétée cyclique des fonctions de hachage respectives jusqu'à ce qu'une correspondance soit trouvée entre le premier syndrome (S(x)) et le syndrome correspondant (Si, Sj) lu depuis la table de correction d'erreur (ECT) au niveau de chaque adresse correspondante (Addrj), sinon la fourniture d'une indication qu'une erreur dans le mot de code récupéré (V!) n'est pas corrigible après une itération à travers la multiplicité de fonctions de hachage des calculateurs d'adresse (Hm).

2. Procédé selon la revendication 1, selon lequel lors de l'étape (c) chacune des M fonctions de hachage (Hfm) est telle que chacune des dites M adresses calculées (Addrm) présente n' bits, n' étant l'entier le plus petit de sorte que 2n' est égal, ou supérieur, à N.

3. Procédé selon la revendication 1, selon lequel l'étape (a) comprend le stockage, au niveau de chacune des dites tables de correction d'erreur (ECT), et au niveau de chaque adresse de table autre que les dites N adresses de table d'un ensemble respectif, d'informations portant sur une erreur incorrigible.

4. Procédé selon la revendication 1, selon lequel l'étape (d) comprend en outre :

(d1) l'utilisation des dites M adresses calculées (Addrm) pour lire dans la table de correction d'erreur (ECT) les M syndromes possibles (Sm) stockés à des adresses de table (Addri(Hfm)) égales aux dites M adresses calculées (Addrm) ;

(d2) la comparaison des dits M syndromes possibles lus (Sm) avec ledit syndrome calculé (S(x)) et ;

(d3) si l'un des dits M syndromes possibles lus (Sm) est égal au dit syndrome calculé (S(x)), la lecture dans la table de correction d'erreur (ECTm) à partir de laquelle ledit un des M syndromes possibles lus (Sm) a été lu lors de l'étape (d1), des informations de correction (Cm*) stockées au niveau d'une adresse de table (Addri(Hfm)) égale à l'adresse calculée (Addrm) au niveau de laquelle ledit un parmi les M syndromes possibles lus (Sm) a été lu lors de l'étape (d1).

5. Produit de programme d'ordinateur comprenant des instructions exécutables par informatique pour la mise en oeuvre, lorsque le programme est exécuté par un ordinateur d'un élément réseau (RX) d'un réseau de communication (CN), d'un procédé de correction d'une ou plusieurs erreurs dans un mot de code (V') reçu au niveau dudit élément réseau (RX), ledit procédé exécutant les étapes selon l'une quelconque des revendications 1 à 4.

6. Moyen de stockage de données numériques stockant un produit de programme d'ordinateur selon la revendication 5.

7. Élément réseau configuré pour corriger une ou plusieurs erreurs, introduites lors d'une transmission via une liaison de communication (L), dans des mots de code d'origine (V) transmis via la liaison de communication (L) et reçus sous forme de mots de code récupérés (V') au niveau de l'élément réseau (RX), l'élément réseau (RX) présentant :

un évaluateur de syndrome (SEV) fournissant un premier syndrome (Sx) dépendant d'un motif d'erreur introduit par la liaison (L) ;
une multiplicité de calculateurs d'adresse (Hm), chacun étant configuré pour recevoir le premier syndrome (Sx) ;
une table de correction d'erreur (ECT) susceptible de recevoir des adresses de multiplexage temporel générées en tant que sorties en provenance de chacun des calculateurs d'adresse (Hm), selon lequel la table de correction d'erreur (ECT) stocke N informations de correction (Ci) permettant de corriger N motifs d'erreur corrigibles (Ei) pouvant affecter lesdits mots de code, la table de correction d'erreur étant construite en appliquant une multiplicité de fonctions de hachage (Hf1-Hf4) à tous les syndromes (Si) et la compilation, pour chacune de la multiplicité de fonctions de hachage, d'une table dans laquelle chaque rangée stocke un syndrome (Si), et son adresse respective (Ai(Hfm) est calculée en appliquant une fonction choisie parmi la multiplicité de fonctions de hachage et selon lequel la table de correction d'erreur (ECT) est assemblée à partir de chacune des tables (T1-T4) par le biais d'une analyse des collisions entre chacune des tables (T1-T4) de sorte que chaque rangée, placée au niveau d'une adresse correspondante dans la table de correction d'erreur, évite des collisions entre différents syndromes calculés via une fonction de hachage commune et chaque rangée de la table de correction stocke (i) l'un des syndromes (Si, Sj) ayant généré cette adresse de la rangée selon l'une quelconque de la multiplicité des fonctions de hachage et (ii) des informations de correction (Cj) permettant la correction d'un parmi une multiplicité de motifs d'erreur corrigibles (Ei) ayant généré le syndrome (Si, Sj) ;
selon lequel, lors de la réception de chaque mot de code récupéré (V') des mots de code d'origine (V), l'élément réseau (RX) est configuré pour :

(a) calculer un syndrome (S(x)) de chacun desdits mots de code récupérés (V') ;
(b) pour chacun de ladite multiplicité de calculateurs d'adresse (Hm), calculer une adresse (Addrm) en appliquant une fonction de hachage respective (Hfm) du calculateur d'adresse audit syndrome calculé (S(x)) du mot de code récupéré (V') ;
(c) effectuer un multiplexage temporel des adresses calculées afin de générer une sortie, dont le résultat est appliqué à chacune des M adresses calculées (Addrm) en provenance de chaque calculateur d'adresse (Hm), mettant en œuvre l'adresse respective pour la lecture d'un syndrome correspondant stocké dans une rangée correspondant à l'adresse dans la table de correction d'erreur (ECT) ; et
(d) utiliser chaque adresse de multiplexage temporel dans la sortie afin d'identifier un syndrome correspondant (Si, Sj) dans la table de correction d'erreur, et retransmettre le syndrome correspondant (Si, Sj) à un comparateur de syndrome (SC) configuré pour comparer le syndrome correspondant avec le premier syndrome ;
(e) fournir le syndrome correspondant à un bloc de correction (CB) qui est en outre susceptible de recevoir le mot de code récupéré (V') ;
(f) utiliser les dites informations de correction choisies (Cm*) afin de corriger une ou plusieurs erreurs affectant chacun des dits mots de code récupérés (V!) en faisant en sorte que le comparateur de syndrome (SC) :

(i) évalue si le syndrome de lecture (Si, Sj) est égal au premier syndrome (S(x)) et, dans l'affirmatif, déterminer que l'adresse (Addrj), au niveau de laquelle le syndrome correspondant (Si, Sj) a été lue, a été calculée en appliquant une première fonction de hachage (Hf1-Hf4) au syndrome correspondant (Si, Sj) et en identifiant qu'un premier motif d'erreur affectant le mot de code récupéré (V') est le motif d'erreur (Ej) stocké au niveau de l'adresse correspondante (Addrj) dans la table de correction d'erreur (ECT), après quoi le comparateur de syndrome (SC) est configuré pour fournir un rapport positif ayant pour effet que le bloc de correction CB lit les informations de correction (Cj) dans la table de correction d'erreur (ECT) au niveau de l'adresse (Addrj) du syndrome correspondant ;

(ii) évalue si le syndrome de lecture (Si, Sj) est différent du premier syndrome (S(x)) et dans l'affirmatif, détermine que l'adresse (Addrj) au niveau de laquelle le syndrome correspondant (Si, Sj) a été lue, a été calculée en appliquant une seconde fonction de hachage différente de la première fonction de hachage (Hf1) au syndrome correspondant (Si, Sj), et en identifiant que le motif d'erreur affectant le mot de code récupéré (V') n'est pas le motif d'erreur (Ej) stocké au niveau de l'adresse correspondante (Addrj), après quoi le comparateur de syndrome (SC) est configuré pour fourni un rapport négatif ayant pour effet que le bloc de correction (CB) ordonne à un second calculateur d'adresse différent (H2-H4) de calculer une seconde adresse différente (Addr2) en appliquant sa fonction de hachage respective (Hf2-Hf4) au premier syndrome S(x) ; et

(iii) évaluer de manière répétée et cyclique les fonctions de hachage respectives jusqu'à ce qu'une correspondance soit trouvée entre le premier syndrome (S(x)) et le syndrome correspondant (Si, Sj) lu depuis la table de correction d'erreur (ECT) au niveau de chaque adresse correspondante (Addrj), sinon fournir une indication qu'une erreur dans le mot de code récupéré (V!) n'est pas corrigible après une itération à travers la multiplicité de fonctions de hachage des calculateurs d'adresse (Hm).

Figure 1

EP 2 285 003 B1

EC

V'

from SL

V

to SE

CB

S(x)

Cm*

Hm

Addrm

ECTm

Sm

SC

CL

S(x)

from SEV

## Figure 2

ECTm

$Addri(Hfm)$

Si

Ci

$2^{n'}$

## Figure 3

Figure 4

EP 2 285 003 B1

Figure 5

Figure 6

Figure 7

**EP 2 285 003 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4382300 A
- US 7260767 B
- US 7353446 B
- EP 0147623 A

**Non-patent literature cited in the description**

- **W.W. PETERSON et al.** Error Correcting Codes. The MIT Press, 1972, 232-234